# EUROPEAN PATENT APPLICATION

(11) **EP 4 808 303 A1**
(43) Date of publication of application: **16.09.2026**
(21) Application number: 23960640.3
(22) Date of filing: 14.12.2023
(51) Int. Cl.: H10B 12/00

(54) **SEMICONDUCTOR DEVICE AND MANUFACTURING METHOD THEREFOR**

(30) Priority: 04.12.2023 CN 202311686249
(71) Applicant: CXMT Corporation, Hefei City, Anhui Province 230601 (CN)
(72) Inventor: TANG, Yi, Hefei, Anhui 230601 (CN)
(74) Representative: Gulde & Partner
(86) International application number: PCT/CN2023/138777
(87) International publication number: WO 2025/118331

(57) **Abstract**

Embodiments of the present disclosure provide a semiconductor device and a manufacturing method therefor. The manufacturing method includes the following steps. A substrate and a stacked structure located on the substrate are provided. The stacked structure includes semiconductor layers and interlayer insulating layers that are alternately stacked. Multiple channel holes running through the stacked structure are formed. The semiconductor layers located between adjacent channel holes are configured to form back gates. Oxidation processing is performed on the semiconductor layers exposed at sidewalls of the channel holes to form first gate dielectric layers. A channel layer, a second gate dielectric layer, and a gate that cover sidewalls of each of the channel holes are sequentially formed. The channel layer, the second gate dielectric layer, and the gate jointly form a transistor, and each of the back gates is configured to regulate a threshold voltage of the transistor.

## Description

### CROSS-REFERENCE TO RELATED APPLICATIONS

The present disclosure is based on and claims priority of the Chinese Patent Application No. 202311686249.8, filed on December 04, 2023 and entitled "SEMICONDUCTOR DEVICE AND MANUFACTURING METHOD THEREFOR". The above-referenced application is incorporated herein by reference in its entirety.

### TECHNICAL FIELD

Embodiments of the present disclosure relate to the field of semiconductor technologies, and in particular, to a semiconductor device and a manufacturing method therefor.

### BACKGROUND

As memories advance toward higher integration density, the sizes of the memories require scaling (Scaling). However, when the size of a current memory is extremely small, size scaling of the memory may lead to degradation (Degradation) of electrical performance of the memory.

Therefore, structures and performance of current memories need to be further improved.

### SUMMARY

In view of this, embodiments of the present disclosure provide a semiconductor device and a manufacturing method therefor.

To achieve the foregoing objective, the technical solutions of the present disclosure are implemented as follows:
According to a first aspect, an embodiment of the present disclosure provides a manufacturing method for a semiconductor device. The manufacturing method includes the following steps.

A substrate and a stacked structure located on the substrate are provided. The stacked structure includes semiconductor layers and interlayer insulating layers that are alternately stacked.

Multiple channel holes running through the stacked structure are formed. The semiconductor layers located between adjacent channel holes are configured to form back gates.

Oxidation processing is performed on the semiconductor layers exposed at sidewalls of the channel holes to form first gate dielectric layers.

A channel layer, a second gate dielectric layer, and a gate that cover sidewalls of each of the channel holes are sequentially formed. The channel layer, the second gate dielectric layer, and the gate jointly form a transistor, and each of the back gates is configured to regulate a threshold voltage of the transistor.

In some embodiments, before the multiple channel holes running through the stacked structure are formed, the manufacturing method further includes the following steps.

Multiple groove groups running through the stacked structure and arranged in a first direction are formed. Each of the groove groups includes a first groove and a second groove that are disposed side by side in a second direction. The remaining stacked structure includes a first stacked sub-structure located between the first groove and the second groove, a second stacked sub-structure located between adjacent first grooves, a third stacked sub-structure located between adjacent second grooves, a fourth stacked sub-structure located between adjacent first stacked sub-structures, and a fifth stacked sub-structure located on a side of the first groove and a side of the second stacked sub-structure, and both the first direction and the second direction are parallel to the substrate and the first direction and the second direction intersect with each other.

The first grooves and the second grooves are filled with an isolation material to form isolation structures.

In some embodiments, before the multiple channel holes running through the stacked structure are formed, the manufacturing method further includes the following step.

At least the fourth stacked sub-structure in the remaining stacked structure is etched to form the multiple channel holes running through the stacked structure and arranged in the first direction.

In some embodiments, after the channel layer, the second gate dielectric layer, and the gate that cover the sidewalls of each of the channel holes are sequentially formed, the manufacturing method further includes the following steps.

The interlayer insulating layers in the first stacked sub-structure are removed to form first gaps. The first gaps expose parts of the channel layer that are disposed opposite to each other in the first direction.

The channel layer exposed through the first gaps is removed.

The first gaps are filled with an isolation material to form first interlayer isolation layers.

In some embodiments, removal of the interlayer insulating layers in the first stacked sub-structure to form the first gaps includes the following steps.

Etching is performed to form a threshold voltage regulation hole running through the first stacked sub-structure. The threshold voltage regulation hole is located between adjacent channel holes. The remaining semiconductor layers located between the adjacent channel holes serve as the back gates.

Lateral etching is performed along the threshold voltage regulation hole to remove the interlayer insulating layers to form the first gaps. The threshold voltage regulation hole and the first gaps are in communication.

In some embodiments, filling of the first gaps with the isolation material to form the first interlayer isolation layers includes the following steps.

The first gaps and the threshold voltage regulation hole are filled with the isolation material.

The isolation material is removed from the threshold voltage regulation hole. The isolation material located in the first gaps forms the first interlayer isolation layers.

The threshold voltage regulation hole is filled with a conductive material to form a threshold voltage regulation structure electrically connected to the back gates. The threshold voltage regulation structure is configured to regulate the threshold voltage of the transistor.

In some embodiments, after the channel layer, the second gate dielectric layer, and the gate that cover the sidewalls of each of the channel holes are sequentially formed, the manufacturing method further includes the following steps.

The interlayer insulating layers in the second stacked sub-structure, the third stacked sub-structure, and the fifth stacked sub-structure are removed to form second gaps. The second gaps expose parts of the channel layer that are disposed opposite to each other in the second direction.

The channel layer exposed through the second gaps is removed.

The second gaps are filled with an isolation material to form second interlayer isolation layers. The first interlayer isolation layers and the second interlayer isolation layers divide the channel layer in each of the channel holes into channel portions of multiple transistors, two opposite sidewalls of each of the channel portions in the second direction respectively form a first source/drain and a second source/drain, multiple transistors arranged in a third direction are connected to the same gate, and the third direction is perpendicular to the substrate.

In some embodiments, after the second gaps are filled with the isolation material to form the second interlayer isolation layers, the manufacturing method further includes the following steps.

The semiconductor layers in the fifth stacked sub-structure are removed to form third gaps. The third gaps expose the first source/drain.

The third gaps are filled with a conductive material to form multiple bit lines extending in the first direction and electrically connected to the first source/drain.

In some embodiments, after the second gaps are filled with the isolation material to form the second interlayer isolation layers, the manufacturing method further includes the following steps.

The semiconductor layers in the third stacked sub-structure are removed to form fourth gaps. The fourth gaps expose the second source/drain.

Storage capacitors electrically connected to the second source/drain are formed in the fourth gaps.

In some embodiments, after the second gaps are filled with the isolation material to form the second interlayer isolation layers, the manufacturing method further includes the following steps.

The semiconductor layers in the fifth stacked sub-structure are removed to form the third gaps. The third gaps expose the first source/drain.

Etching is performed to form the threshold voltage regulation hole running through the first stacked sub-structure. The threshold voltage regulation hole is located between adjacent channel holes. The remaining semiconductor layers located between the adjacent channel holes serve as the back gates.

The third gaps and the threshold voltage regulation hole are simultaneously filled with the conductive material to respectively form the multiple bit lines extending in the first direction and electrically connected to the first source/drain and the threshold voltage regulation structure electrically connected to the back gates. The threshold voltage regulation structure is configured to regulate the threshold voltage of the transistor.

According to a second aspect, an embodiment of the present disclosure provides a semiconductor device. The semiconductor device includes:
a substrate;
multiple channel portions arrayed in a first direction and a third direction, the first direction being parallel to the substrate, and the third direction being perpendicular to the substrate;
a gate extending in the third direction and passing through the channel portions;
a second gate dielectric layer located between the channel portions and the gate, each of the channel portions, the second gate dielectric layer, and the gate jointly forming a transistor;
a first gate dielectric layer covering two sidewalls that are of each of the channel portions and that are disposed opposite to each other in the first direction; and
back gates located between adjacent transistors arranged in the first direction, the back gates being in contact with the first gate dielectric layer, and each of the back gates being configured to regulate a threshold voltage of the transistor.

In some embodiments, two opposite sidewalls of each of the channel portions in a second direction respectively form a first source/drain and a second source/drain; the second direction is parallel to the substrate and intersects with the first direction; and the semiconductor device further includes:
bit lines extending in the first direction, where multiple first sources/drains arranged in the first direction are connected to the same bit line; and
multiple storage capacitors, the storage capacitors being connected to the second source/drain.

In some embodiments, the semiconductor device further includes:
a threshold voltage regulation structure located between adjacent back gates of adjacent channel portions arranged in the first direction, the threshold voltage regulation structure extending in the third direction and being electrically connected to multiple back gates arranged in the third direction.

In some embodiments, each of the channel portions is of a ring-shaped structure parallel to the substrate; and
the size of the channel portion in the second direction is greater than or equal to the size of the back gate in the second direction.

Embodiments of the present disclosure provide a semiconductor device and a manufacturing method therefor. In the embodiments of the present disclosure, the multiple channel holes running through the stacked structure are formed, and the gate is formed in each of the channel holes and the semiconductor layers in the stacked structure serve as the back gates. In this way, the threshold voltage of the transistor can be regulated through the back gate.

### BRIEF DESCRIPTION OF DRAWINGS

FIG. 1 is a schematic diagram of a three-dimensional structure of a semiconductor device according to an example;
FIG. 2 is a schematic flowchart of a manufacturing method for a semiconductor device according to an embodiment of the present disclosure;
FIG. 3A to FIG. 3P are schematic diagrams of three-dimensional structures of a semiconductor device according to an example in a manufacturing procedure;
FIG. 4A to FIG. 4F are schematic diagrams of sectional structures of a semiconductor device according to an example in a manufacturing procedure;
FIG. 5A and FIG. 5B are schematic diagrams of structures of a semiconductor device according to an example; and
FIG. 6A and FIG. 6B are schematic diagrams of structures of a semiconductor device according to another example.

### DESCRIPTION OF EMBODIMENTS

The technical solutions of the implementations of the present disclosure will be described below in detail with reference to the implementations and the accompanying drawings of the present disclosure. Clearly, the described implementations are some rather than all of the implementations of the present disclosure. Based on the implementations of the present disclosure, all other implementations obtained by a person of ordinary skill in the art without creative efforts fall within the protection scope of the present disclosure.

In the following descriptions, a large quantity of specific details are given to provide a more thorough understanding of the present disclosure. However, it is obviously to a person skilled in the art that the present disclosure may be implemented without one or more of these details. In other examples, some technical features well-known in the art are not described to avoid confusion with the present disclosure. That is, not all features of actual embodiments are described herein, and well-known functions and structures are not described in detail.

In the accompanying drawings, for clarity, sizes of a layer, a region, and an element, and relative sizes thereof may be exaggerated. The same reference numerals always indicate the same elements.

It should be understood that, an element or a layer may be directly on, adjacent to, connected to, or coupled to another element or layer or there may be an intermediate element or layer when the element or the layer is referred to as "on", "adjacent to", "connected to", or "coupled to" the another element or layer. Instead, there is no intermediate element or layer when an element is referred to as "directly on", "directly adjacent to", "directly connected to", or "directly coupled to" another element or layer. It should be understood that, although the terms "first", "second", "third", and the like may be utilized to describe various elements, components, regions, layers, and/or portions, these elements, components, regions, layers, and/or portions shall not be limited by these terms. These terms are merely utilized to distinguish one element, component, region, layer, or portion from another element, component, region, layer, or portion. Therefore, a first element, component, region, layer, or portion discussed below may be represented as a second element, component, region, layer, or portion without departing from the teachings of the present disclosure. However, when the second element, component, region, layer, or portion is discussed, it does not necessarily indicate that there is the first element, component, region, layer, or portion necessarily in the present disclosure.

Spatial relationship terms, e.g., "under", "below", "underlying", "beneath", "over", and "above" may be utilized herein for convenience of description, to describe the relationship between one element or feature and another element or feature shown in the figures. It should be understood that in addition to the orientations shown in the figures, the spatial relationship terms are further intended to include different orientations of components in use and operation. An element or a feature described as "below another element" is oriented to be "above" the another element or feature, for example, if the components in the accompanying drawings are flipped. Therefore, the example terms "below" and "beneath" may include orientations of being above and being below. The component may be otherwise oriented (rotated by 90 degrees or oriented in another manner), and the spatial descriptors utilized herein are interpreted accordingly.

The terms utilized herein are intended merely to describe specific embodiments and are not construed as a limitation on the present disclosure. As utilized herein, the singular forms "a/an", "one", and "the" are also intended to include plural forms unless the context clearly indicates otherwise. It should also be understood that the terms "constitute" and/or "include" are utilized in the specification to determine the presence of the feature, integer, step, operation, element, and/or component, but not rule out the presence or addition of one or more other features, integers, steps, operations, elements, components, and/or groups. As utilized herein, the term "and/or" includes any and all combinations of the related items listed.

For a thorough understanding of the present disclosure, detailed steps and detailed structures are provided in the following descriptions to illustrate the technical solutions of the present disclosure. Preferred embodiments of the present disclosure are described in detail as follows. However, the present disclosure may have other implementations in addition to these detailed descriptions.

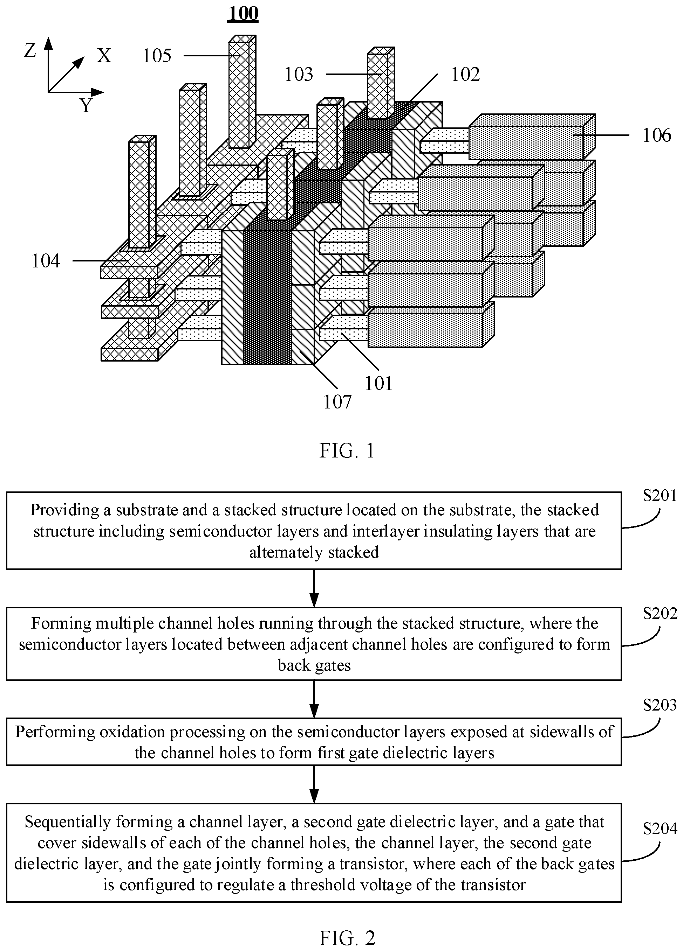

Referring to FIG. 1, FIG. 1 is a schematic diagram of a three-dimensional structure of a semiconductor device according to an example. As shown in FIG. 1, the semiconductor device 100 includes: a substrate (not shown in FIG. 1) and multiple semiconductor pillars 101 located on the substrate, the semiconductor pillars 101 extending in a Y direction and being arrayed in an X direction and a Z direction, and in the extension direction, each of the semiconductor pillars 101 including a source, a drain, and a channel region located between the source and the drain; word lines 102 surrounding channel regions of the semiconductor pillars 101, where the word lines 102 extend in the Z direction and multiple semiconductor pillars 101 arranged in the Z direction are connected to the same word line 102; bit lines 104 connected to sources or drains of the semiconductor pillars 101, where the bit lines 104 extend in the X direction and sources or drains of multiple semiconductor pillars 101 arranged in the X direction are connected to the same bit line 104; and storage capacitors 106 connected to the drains or the sources of the semiconductor pillars 101, the storage capacitors 106 extending in the Y direction.

In the foregoing example, an angle between the X direction and the Y direction is 90 degrees, and both the X direction and the Y direction are perpendicular to the Z direction. In another example, the angle between the X direction and the Y direction may alternatively be another angle, for example, 30 degrees, or 45 degrees. An angle between two of the X direction, the Y direction, and the Z direction is not limited in this example.

As shown in FIG. 1, the semiconductor device 100 further includes: multiple word-line extension lines 103, the word-line extension lines 103 extending in the Z direction and being arranged in the X direction, and the bottoms of different word-line extension lines 103 being connected to different word lines 102; and multiple bit-line extension lines 105, the bit-line extension lines 105 extending in the Z direction and being arranged in the X direction, and the bottoms of different bit-line extension lines 105 being connected to different bit lines 104.

The semiconductor device 100 further includes isolation layers 107. The isolation layers 107 extend in the X-direction. Each of the word lines 102 is located between adjacent isolation layers 107 in the Y-direction. The semiconductor pillars 101 pass through the isolation layers 107 in the Y direction. The isolation layers 107 may isolate the word lines 102 from the sources and the drains of the semiconductor pillars 101, to avoid electric leakage between the channel regions and the sources or the drains of transistors formed through the semiconductor pillars, thereby preventing the performance of the semiconductor device from being affected.

The semiconductor device 100 in the foregoing example is a three-dimensional dynamic random access memory (3D Dynamic Random Access Memory, 3D DRAM) of a structure in which one transistor corresponds to one storage capacitor (1T1C). An indium gallium zinc oxide (Indium Gallium Zinc Oxide, IGZO) is utilized as a channel material of the DRAM, to further reduce electric leakage to improve the electrical performance of the DRAM. In addition, a manufacturing process of the DRAM is relatively simple and costs are relatively low, so that the DRAM has become an important research object in the current industry.

However, a threshold voltage of the IGZO as an N-type semiconductor material is more inclined to a negative voltage, but for the DRAM, a positive threshold voltage is more conducive to reducing electric leakage, thereby prolonging a retention time (Retention Time) of stored data.

In view of this, embodiments of the present disclosure provide a semiconductor device and a manufacturing method therefor.

Referring to FIG. 2, FIG. 2 is a schematic flowchart of a manufacturing method for a semiconductor device according to an embodiment of the present disclosure. As shown in FIG. 2, an embodiment of the present disclosure provides a manufacturing method for a semiconductor device. The manufacturing method includes the following steps.

In the step of S201, a substrate and a stacked structure located on the substrate are provided. The stacked structure includes semiconductor layers and interlayer insulating layers that are alternately stacked.

In the step of S202, multiple channel holes running through the stacked structure are formed. The semiconductor layers located between adjacent channel holes are configured to form back gates.

In the step of S203, oxidation processing is performed on the semiconductor layers exposed at sidewalls of the channel holes to form first gate dielectric layers.

In the step of S204, a channel layer, a second gate dielectric layer, and a gate that cover sidewalls of each of the channel holes are sequentially formed. The channel layer, the second gate dielectric layer, and the gate jointly form a transistor, and each of the back gates is configured to regulate a threshold voltage of the transistor.

In this embodiment of the present disclosure, the multiple channel holes running through the stacked structure are formed, and the first gate dielectric layer, the channel layer, the second gate dielectric layer, and the gate are sequentially formed in each of the channel holes. The channel layer, the second gate dielectric layer, and the gate jointly form the transistor, and the original semiconductor layers in the stacked structure serve as the back gates. In this way, the threshold voltage of the transistor can be regulated through the back gate.

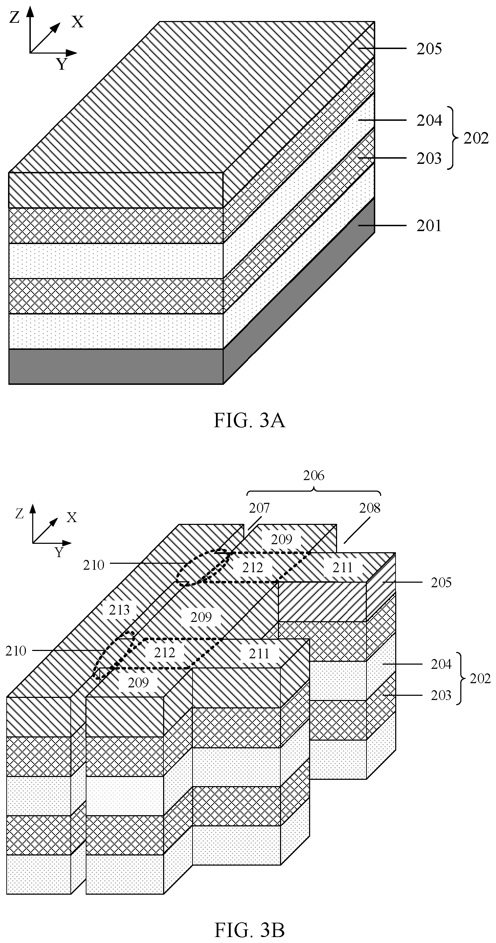

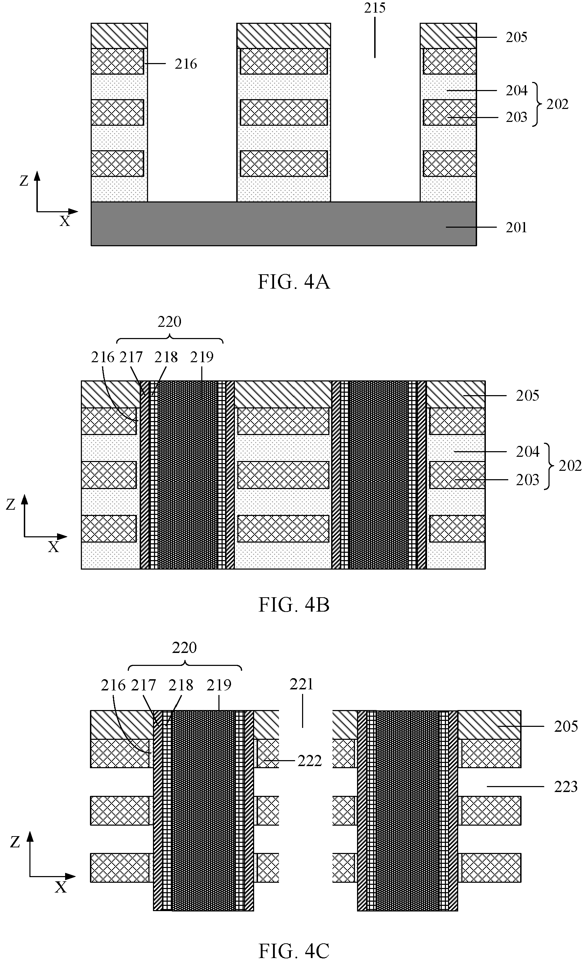

Referring to FIG. 3A to FIG. 3P, FIG. 3A to FIG. 3P are schematic diagrams of three-dimensional structures of a semiconductor device according to an example in a manufacturing procedure. Referring to FIG. 4A to FIG. 4F, FIG. 4A to FIG. 4F are schematic diagrams of sectional structures of a semiconductor device according to an example in a manufacturing procedure. The manufacturing procedure of the semiconductor device is described in detail below with reference to FIG. 3A to FIG. 3P and FIG. 4A to FIG. 4F.

In this embodiment of the present disclosure, in the step of S201, a substrate 201 and a stacked structure 202 located on the substrate 201 are provided. The stacked structure 202 includes semiconductor layers 203 and interlayer insulating layers 204 that are alternately stacked.

As shown in FIG. 3A, the semiconductor layers 203 and the interlayer insulating layers 204 that are successively alternately stacked are formed on the substrate 201. The semiconductor layers 203 and the interlayer insulating layers 204 that are alternately stacked jointly form the stacked structure 202. A cover layer 205 is formed on the stacked structure 202.

The substrate 201 may be a semiconductor substrate, and specifically includes at least one monoatomic semiconductor material (for example, a silicon (Si) substrate or a germanium (Ge) substrate), at least one III-V compound semiconductor material (for example, a gallium nitride (GaN) substrate, a gallium arsenide (GaAs) substrate, or an indium phosphide (InP) substrate), at least one II-VI compound semiconductor material, at least one organic semiconductor material, or another semiconductor material known in the art, or may include another substrate including a semiconductor material, for example, a silicon on insulator (SOI) substrate, a germanium on insulator (GeOI) substrate, a multi-crystal semiconductor layer on an insulating layer, or a silicon-germanium substrate.

The material of the semiconductor layers 203 may include but is not limited to a polysilicon material. The material of the interlayer insulating layers 204 may include but is not limited to a silicon oxide material. Quantities and thicknesses of semiconductor layers and interlayer insulating layers are not specifically limited in the present disclosure.

The material of the cover layer 205 may include but is not limited to a silicon nitride material.

A process of forming the semiconductor layers 203, the interlayer insulating layers 204, and the cover layer 205 may include but is not limited to chemical vapor deposition (Chemical Vapor Deposition, CVD), physical vapor deposition (Physical Vapor Deposition, PVD), atomic layer deposition (Atomic Layer Deposition, ALD), or any combination thereof.

In this embodiment of the present disclosure, the thickness direction of the substrate is defined as a third direction, that is, a Z direction. Alternatively, a direction perpendicular to a surface of the substrate is defined as a third direction, that is, a Z direction. A first direction and a second direction that intersect with each other are defined in a plane perpendicular to the third direction. The first direction is an X direction and the second direction is a Y direction. In an example, two of the X direction, the Y direction, and the Z direction may be perpendicular to each other.

As shown in FIG. 3B, in some embodiments, before the step of S202, the manufacturing method further includes the following step. The cover layer 205 and the stacked structure 202 are sequentially etched in the Z direction to form multiple groove groups 206 running through the stacked structure and arranged in the first direction (that is, the X direction). Each of the groove groups 206 includes a first groove 207 and a second groove 208 that are disposed in parallel in the second direction (that is, the Y direction). FIG. 3B shows three groove groups 206 sequentially arranged in the X direction. Each of the groove groups 206 includes a first groove 207 and a second groove 208 that are disposed in parallel in the Y direction.

A process of forming the first groove 207 and the second groove 208 may include but is not limited to wet etching, dry etching, or a combination thereof.

First grooves 207 and second grooves 208 divide the stacked structure 202 into multiple components. The remaining stacked structure 202 includes a first stacked sub-structure 209 located between the first groove 207 and the second groove 208, a second stacked sub-structure 210 (as shown by a dashed circle in FIG. 3B) located between two adjacent first grooves 207 in the X direction, a third stacked sub-structure 211 located between two adjacent second grooves 208 in the X direction, a fourth stacked sub-structure 212 (as shown by a dashed square in FIG. 3B) located between two adjacent first stacked sub-structures 209 in the X direction, and a fifth stacked sub-structure 213 located on a side of the first groove 207 and a side of the second stacked sub-structure 210. The fourth stacked sub-structure 212 is also located between the second stacked sub-structure 210 and the third stacked sub-structure 211 that are arranged in the Y direction, and a region in which the fourth stacked sub-structure 212 is located is configured to form the transistor of the semiconductor device.

The remaining stacked structure is divided to facilitate describing the manufacturing procedure of the semiconductor device, a difference between different stacked sub-structures lies in positional relationships thereof relative to the first groove and the second groove.

In addition, for ease of illustration of the accompanying drawings, none of FIG. 3B to FIG. 3P shows the substrate.

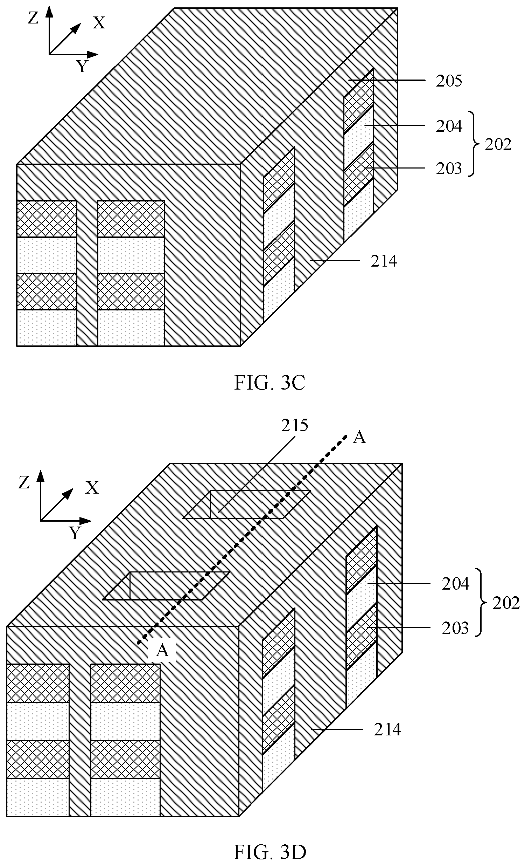

As shown in FIG. 3B and FIG. 3C, the first grooves 207 and the second grooves 208 are filled with an isolation material to form isolation structures 214.

A process of forming the semiconductor layers 203 and the interlayer insulating layers 204 may include but is not limited to CVD, PVD, ALD, or any combination thereof.

The material of the isolation structures 214 may include a low dielectric constant material, for example, silicon oxide, silicon nitride, silicon carbide, nitrogenous silicon carbide, or silicon oxynitride. In some embodiments, the cover layer 205 and the isolation structures 214 may be made of the same material or different materials. FIG. 3C shows that the cover layer 205 and the isolation structures 214 are made of the same material, that is, a silicon nitride material. The top surface of the cover layer 205 may be flush with the top surfaces of the isolation structures 214.

In this embodiment of the present disclosure, in the step of S202, multiple channel holes 215 running through the stacked structure 202 are formed. The semiconductor layers 203 located between adjacent channel holes 215 are configured to form back gates 222.

As shown in FIG. 3D, in some embodiments, the step of S202 includes the following step. In the Z direction, the cover layer 205 and at least fourth the stacked sub-structure 212 in the stacked structure 202 are sequentially etched to form the multiple channel holes 215 running through the stacked structure 202 and arranged in the first direction (that is, the X direction). An orthographic projection area of each of the channel holes 215 on the substrate (that is, an XY plane) is greater than or equal to an orthographic projection area of the fourth stacked sub-structure 212 on the substrate (that is, the XY plane).

In some examples, only the fourth stacked sub-structure 212 in the stacked structure 202 is etched. Then, an orthographic projection area of each of the formed channel holes 215 on the XY plane is equal to an orthographic projection area of the fourth stacked sub-structure 212 on the XY plane. In some examples, the fourth stacked sub-structure 212 and at least a part of the first stacked sub-structure 209 in the stacked structure 202 are simultaneously etched. Then, the size of each of the formed channel holes 215 in the X direction is greater than the size of the fourth stacked sub-structure 212 in the X direction, and an orthographic projection area of each of the channel holes 215 on the XY plane is greater than an orthographic projection area of the fourth stacked sub-structure 212 on the XY plane. In some examples, the fourth stacked sub-structure 212 and at least a part of the second stacked sub-structure 210 and/or at least a part of the third stacked sub-structure 211 in the stacked structure 202 are simultaneously etched. Then, the size of each of the formed channel holes 215 in the Y direction is greater than the size of the fourth stacked sub-structure 212 in the Y direction, and an orthographic projection area of each of the channel holes 215 on the XY plane is greater than an orthographic projection area of the fourth stacked sub-structure 212 on the XY plane.

It should be noted that when only the fourth stacked sub-structure 212 in the stacked structure 202 is etched, a bit line contact structure may be subsequently formed in a space occupied by the second stacked sub-structure 210.

A process of forming the channel holes 215 may include but is not limited to wet etching, dry etching, or a combination thereof.

In this embodiment of the present disclosure, orthographic projections of the channel holes 215 on the XY plane may be quadrilateral, and each of the channel holes 215 includes four sidewalls. Two of the sidewalls are disposed opposite to each other in the X direction, and the other two of the sidewalls are disposed opposite to each other in the Y direction. In another embodiment, orthographic projections of the channel holes 215 on the XY plane may alternatively be circular or oval. Then, each of the channel holes 215 includes at least two end portions disposed opposite to each other in the Y direction. The shape of the orthographic projections of the channel holes 215 on the XY plane is not specifically limited in the present disclosure.

In this embodiment of the present disclosure, in the step of S203, oxidation processing is performed on the semiconductor layers 203 exposed at sidewalls of the channel holes 215 to form first gate dielectric layers 216.

FIG. 3D cannot show an internal structure of the channel holes 215. Referring to FIG. 4A, FIG. 4A is a schematic diagram of an XZ sectional structure along a cross section A-A in FIG. 3D. As shown in FIG. 4A, the bottoms of the channel holes 215 formed through etching expose the substrate 201, and the sidewalls of the channel holes 215 expose sidewalls of the semiconductor layers 203 and the interlayer insulating layers 204 that are alternately stacked and sidewalls of the cover layer 205. Oxidation processing is performed on the semiconductor layers 203 exposed at the sidewalls of the channel holes 215 to form the first gate dielectric layers 216.

The material of the semiconductor layers 203 may include but is not limited to a polysilicon material, but a silicon oxide material may be formed after oxidation processing.

In this embodiment of the present disclosure, in the step of S204, a channel layer 217, a second gate dielectric layer 218, and a gate 219 that cover sidewalls of each of the channel holes 215 are sequentially formed. The channel layer 217, the second gate dielectric layer 218, and the gate 219 jointly form a transistor 220, and each of the back gates 222 is configured to regulate a threshold voltage of the transistor 220. In some examples, the semiconductor layers 203 may be made of a P-type heavily doped polysilicon material with a doping concentration of 1E21 cm⁻³ to 1E23 cm⁻³ and a work function of 4 eV to 5.5 eV.

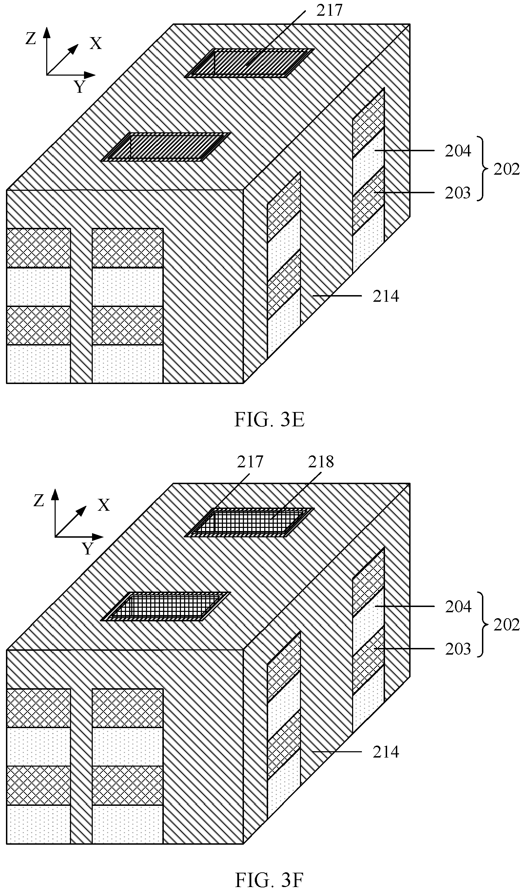

As shown in FIG. 3E, the channel layer 217 covering the sidewalls of each of the channel holes 215 is formed. The channel layer 217 directly contacts the first gate dielectric layers 216 and the interlayer insulating layers 204 that are exposed at the sidewalls of the channel hole 215 and that are alternately disposed.

The material of the channel layer 217 may include but is not limited to an oxide semiconductor material, for example, IGZO, zinc tin oxide (Zinc Tin Oxide, ZTO), indium zinc oxide (Indium Zinc Oxide, IZO), zinc oxide, indium gallium silicon oxide (Indium Gallium Silicon Oxide, IGSO), or indium oxide.

As shown in FIG. 3F, the second gate dielectric layer 218 covering the sidewalls of each of the channel holes 215 is formed. The second gate dielectric layer 218 directly contacts the channel layer 217 in the channel hole 215.

The material of the second gate dielectric layer 218 may include but is not limited to a high dielectric constant material, a silicon oxide material, a silicon nitride material, a silicon oxynitride material, or a combination thereof.

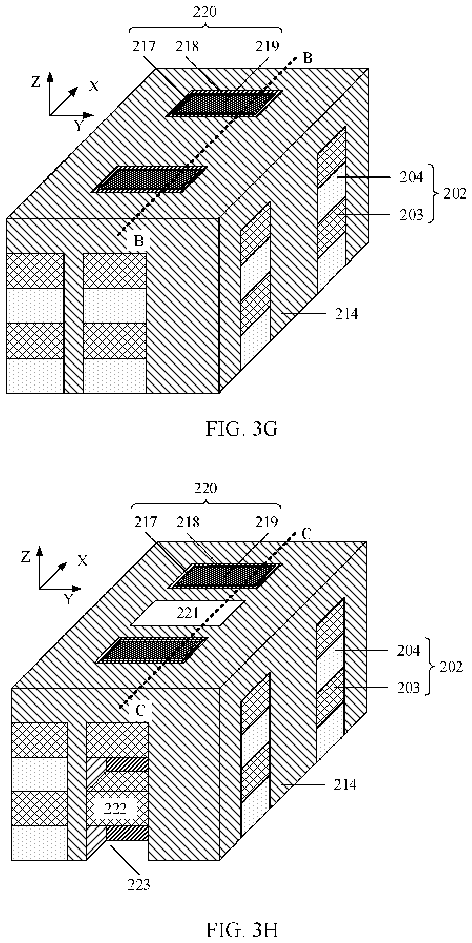

As shown in FIG. 3G, each of the channel holes 215 is fully filled with a conductive material to form the gate 219. The gate 219 directly contacts the second gate dielectric layer 218 in the channel hole 215.

For example, the channel hole 215 is filled with the conductive material, and the conductive material may be located on the surface of the cover layer 205 while fully filling the channel hole 215. Planarization processing is performed on the conductive material, so that the surface of the conductive material in the channel hole 215 is basically flush with the surface of the cover layer 205 to expose the surface of the cover layer 205. The conductive material in the channel hole 215 forms the gate 219.

The material of the gate 219 may include but is not limited to metal, a metal compound, or alloy. The metal may be, for example, copper, aluminum, tungsten, gold, or silver. The metal compound may be, for example, tantalum nitride or titanium nitride. The alloy may be alloy formed through at least two metal elements in copper, aluminum, tungsten, gold, or silver.

A process of forming the channel layer 217, the second gate dielectric layer 218, and the gate 219 may include but is not limited to CVD, PVD, ALD, or any combination thereof.

Referring to FIG. 4B, FIG. 4B is a schematic diagram of an XZ sectional structure along a cross section B-B in FIG. 3G. As shown in FIG. 4B, each of the channel holes 215 sequentially includes the first gate dielectric layers 216, the channel layer 217, the second gate dielectric layer 218, and the gate 219 in a radial inward direction. The semiconductor layers 203 and the interlayer insulating layers 204 that are alternately stacked in the stacked structure surround the channel hole 215, and the semiconductor layers 203 directly contact the first gate dielectric layers 216. The channel layer 217, the second gate dielectric layer 218, and the gate 219 shown in FIG. 3G and FIG. 4B jointly form the transistor 220. The transistor 220 may be a channel all around (Channel All Around, CAA) transistor. The second gate dielectric layer 218 surrounds the gate 219, and the channel layer 217 surrounds the second gate dielectric layer 218.

In addition, for ease of illustration of the accompanying drawings, none of FIG. 4B to FIG. 4F shows the substrate.

In some embodiments, after the step of S204, the manufacturing method further includes the following steps.

The interlayer insulating layers 204 in the first stacked sub-structure 209 are removed to form first gaps 223. The first gaps 223 expose parts of the channel layer 217 that are disposed opposite to each other in the first direction.

The channel layer 217 exposed through the first gaps 223 is removed.

The first gaps 223 are filled with an isolation material to form first interlayer isolation layers 224.

As shown in FIG. 3H, in some embodiments, removal of the interlayer insulating layers 204 in the first stacked sub-structure 209 to form the first gaps 223 includes the following steps. In the Z direction, the cover layer 205 and the first stacked sub-structure 209 in the stacked structure 202 are sequentially etched to form a threshold voltage regulation hole 221 running through the first stacked sub-structure 209. The threshold voltage regulation hole 221 is located between adjacent channel holes 215 in the X direction, and the remaining semiconductor layers 203 located between the adjacent channel holes 215 in the X direction serve as the back gates 222. Through the threshold voltage regulation hole 221, lateral etching is (that is, in the X direction) performed along the threshold voltage regulation hole 221 to remove the interlayer insulating layers 204 in the first stacked sub-structure 209 to form the first gaps 223. The threshold voltage regulation hole 221 and the first gaps 223 are in communication.

A process of forming the threshold voltage regulation hole 221 and the first gaps 223 may include but is not limited to wet etching, dry etching, or a combination thereof.

Referring to FIG. 4C, FIG. 4C is a schematic diagram of an XZ sectional structure along a cross section C-C in FIG. 3H. As shown in FIG. 3H and FIG. 4C, after the threshold voltage regulation hole 221 and the first gaps 223 are formed, the first gaps 223 expose the parts of the channel layer 217 that are disposed opposite to each other in the X direction. In other words, in this case, the first gaps 223 expose the channel layer 217 located on two opposite sidewalls of the channel hole 215 in the X direction.

The remaining semiconductor layers located between the adjacent channel holes 215 in the X direction serve as the back gates 222. The first gate dielectric layers 216 are located between the channel layer 217 and the back gates 222. The second gate dielectric layer 218 is located between the channel layer 217 and the gate 219.

In this embodiment of the present disclosure, the stacked structure including the semiconductor layers and the interlayer insulating layers that are alternately stacked is formed, the remaining semiconductor layers that are located between the adjacent channel holes and that are obtained after etching serve as the back gates subsequently without additionally forming back gates. In this way, the manufacturing process of the semiconductor device can be simplified. In addition, the threshold voltage of the transistor may be regulated through the back gate to reduce a leakage current of the semiconductor device, thereby improving electrical performance of the semiconductor device.

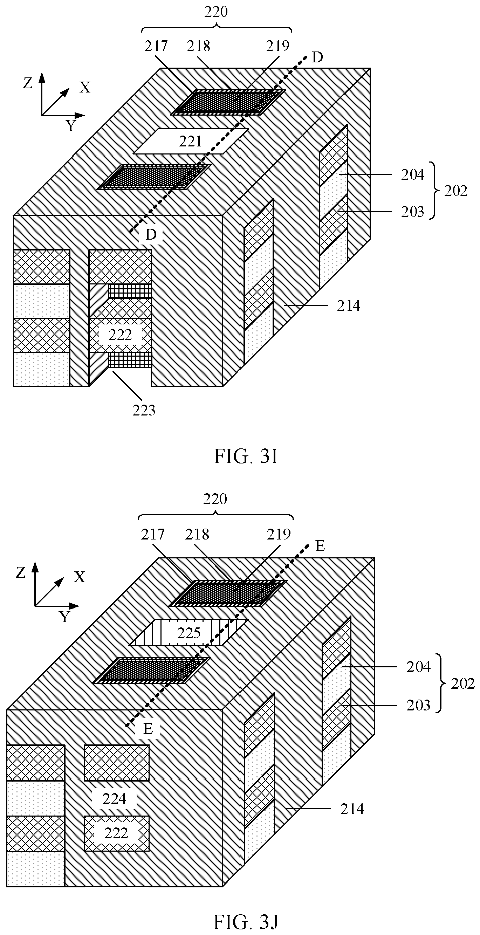

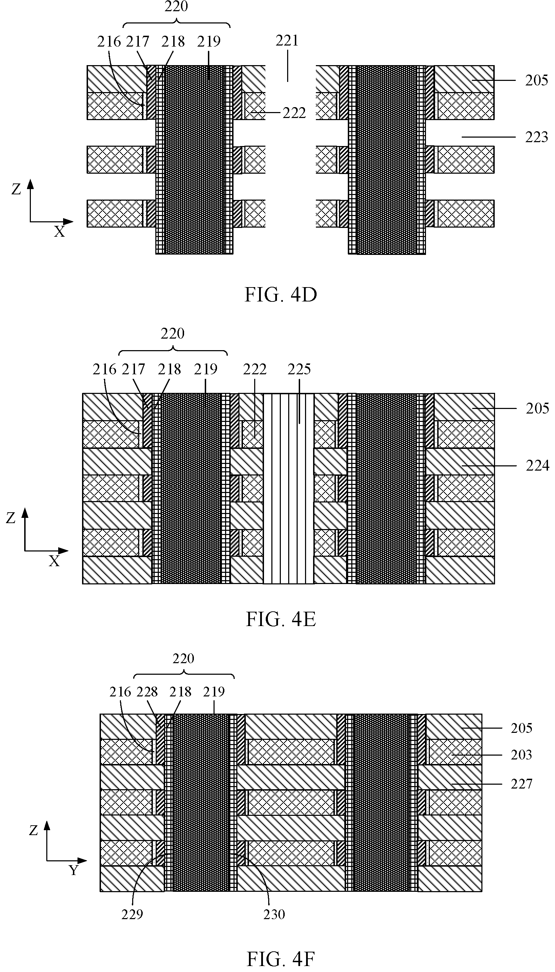

Referring to FIG. 3I and FIG. 4D, FIG. 4D is a schematic diagram of an XZ sectional structure along a cross section D-D in FIG. 3I. As shown in FIG. 3I and FIG. 4D, the channel layer 217 exposed through the first gaps 223 is laterally removed through etching. In this case, the first gaps 223 expose parts of the second gate dielectric layer 218 that are disposed opposite to each other in the X direction. In other words, in this case, the first gaps 223 expose the second gate dielectric layer 218 located on the two opposite sidewalls of each of the channel holes 215 in the X direction.

A process of removing the channel layer 217 exposed through the first gaps 223 may include but is not limited to wet etching, dry etching, or a combination thereof.

Referring to FIG. 3J and FIG. 4E, FIG. 4E is a schematic diagram of an XZ sectional structure along a cross section E-E in FIG. 3J. As shown in FIG. 3J and FIG. 4E, in some embodiments, filling of the first gaps 223 with the isolation material to form the first interlayer isolation layers 224 includes: The first gaps 223 and the threshold voltage regulation hole 221 are filled with the isolation material through the threshold voltage regulation hole 221, so that at least the first gaps 223 are fully filled with the isolation material. The isolation material located in the first gaps 223 forms the first interlayer isolation layers 224.

The first interlayer isolation layers 224 directly contact the second gate dielectric layer 218 on the two opposite sidewalls of the channel hole 215 in the X direction. FIG. 4E shows that the channel layer 217 on the two opposite sidewalls of the channel hole 215 in the X direction is divided by multiple first interlayer isolation layers 224. In this way, the channel layer 217 in the schematic diagram of the XZ sectional structure is divided by the first interlayer isolation layers 224.

The material of the first interlayer isolation layers 224 may include but is not limited to a low dielectric constant material, for example, at least one of silicon oxide, silicon nitride, silicon carbide, nitrogenous silicon carbide, or silicon oxynitride.

As shown in FIG. 3J and FIG. 4E, the isolation material in the threshold voltage regulation hole 221 is removed. A conductive material is filled in the threshold voltage regulation hole 221 to form a threshold voltage regulation structure 225 electrically connected to the back gates 222. The threshold voltage regulation structure 225 is configured to regulate the threshold voltage of the transistor 220.

Both two opposite sidewalls of the threshold voltage regulation structure 225 in the Z direction contact the back gates.

In this embodiment of the present disclosure, the threshold voltage regulation structure may be further formed. The threshold voltage of the transistor may be further regulated through the threshold voltage regulation structure when the threshold voltage of the transistor is regulated through the back gate, thereby improving a regulation effect of the threshold voltage of the transistor.

The material of the threshold voltage regulation structure 225 may include but is not limited to metal, a metal compound, or alloy. The metal may be, for example, copper, aluminum, tungsten, gold, or silver. The metal compound may be, for example, tantalum nitride or titanium nitride. The alloy may be alloy formed through at least two metal elements in copper, aluminum, tungsten, gold, or silver.

A process of forming the first interlayer isolation layers 224 and the threshold voltage regulation structure 225 may include but is not limited to CVD, PVD, ALD, or any combination thereof.

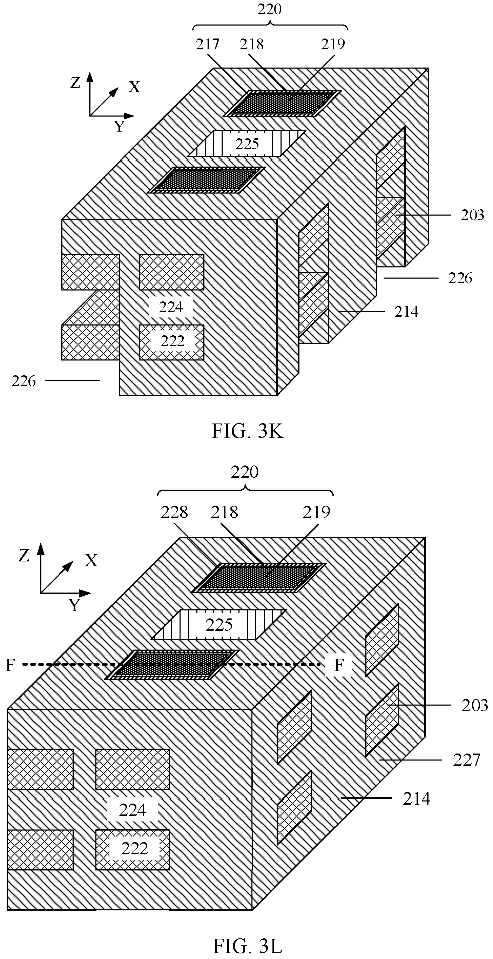

As shown in FIG. 3K, in some embodiments, after the channel layer 217, the second gate dielectric layer 218, and the gate 219 that cover the sidewalls of each of the channel holes 215 are sequentially formed, the manufacturing method further includes the following step. The interlayer insulating layers 204 in the second stacked sub-structure 210, the third stacked sub-structure 211, and the fifth stacked sub-structure 213 are removed through etching to form second gaps 226. In this case, the second gaps 226 expose parts of the channel layer 217 that are disposed opposite to each other in the Y direction. In other words, in this case, the second gaps 226 expose the channel layer 217 located on the two opposite sidewalls of the channel hole 215 in the Y direction.

A process of forming the second gaps 226 may include but is not limited to wet etching, dry etching, or a combination thereof.

As shown in FIG. 3K, the channel layer 217 exposed through the second gaps 226 is removed. In this case, the second gaps 226 expose parts of the second gate dielectric layer 218 that are disposed opposite to each other in the Y direction. In other words, in this case, the second gaps 226 expose the second gate dielectric layer 218 located on the two opposite sidewalls of the channel hole 215 in the Y direction.

A process of removing the channel layer 217 exposed through the second gaps 226 may include but is not limited to wet etching, dry etching, or a combination thereof.

By removing the parts of the channel layer 217 that correspond to the interlayer insulating layers 204, the channel layer 217 between transistors 220 is disconnected in the Z direction to form channel portions 228 in a self-aligned manner, so that mutual interference between adjacent transistors 220 can be avoided, thereby reducing electric leakage of the transistors 220.

Still as shown in FIG. 3L, the second gaps 226 are filled with an isolation material to form second interlayer isolation layers 227. The first interlayer isolation layers 224 and the second interlayer isolation layers 227 divide the channel layer 217 in each of the channel holes 215 into channel portions 228 of multiple transistors 220. In this way, the channel layer 217 in the schematic diagram of the XZ sectional structure and the schematic diagram of the YZ sectional structure is divided by both the first interlayer isolation layers 224 and the second interlayer isolation layers 227.

Referring to FIG. 4F, FIG. 4F is a schematic diagram of a YZ sectional structure along a cross section F-F in FIG. 3H. As shown in FIG. 3L and FIG. 4F, the second interlayer isolation layers 227 contact the second gate dielectric layer 218 on the two opposite sidewalls of the channel hole 215 in the Y direction. The channel layer 217 on the two opposite sidewalls of the channel hole 215 in the X direction is divided by the multiple first interlayer isolation layers 224, that is, the first interlayer isolation layers 224 and the second interlayer isolation layers 227 jointly divide the channel layer 217 in each of the channel holes 215 into the channel portions 228 of the multiple transistors 220 to form the multiple transistors 220 arranged in the Z direction. The multiple transistors 220 arranged in the Z direction are connected to the same gate 219, and multiple transistors 220 arranged in the X direction are connected to different gates 219.

The material of the second interlayer isolation layers 227 may include but is not limited to a low dielectric constant material, for example, at least one of silicon oxide, silicon nitride, silicon carbide, nitrogenous silicon carbide, or silicon oxynitride.

A process of forming the second interlayer isolation layers 227 may include but is not limited to CVD, PVD, ALD, or any combination thereof.

In this embodiment of the present disclosure, the interlayer insulating layers 204 in the first stacked sub-structure 209 are first removed through etching to form the first gaps 223, and the interlayer insulating layers 204 in the second stacked sub-structure 210, the third stacked sub-structure 211, and the fifth stacked sub-structure 213 are then removed through etching to form the second gaps 226. That is, the first interlayer isolation layers 224 are formed first, and then the second interlayer isolation layers 227 are formed.

In another embodiment, the second gaps may be formed before the first gaps are formed, that is, the second interlayer isolation layers may be formed before the first interlayer isolation layers are formed. In some other embodiments, the second gaps and the first gaps may be simultaneously formed, and the exposed parts of the channel layer may be simultaneously removed through the second gaps and the first gaps. A process sequence of forming the first gaps and the second gaps is not specifically limited in the present disclosure, provided that the channel layer can be divided into the multiple channel portions arranged in the Z direction.

In this embodiment of the present disclosure, the transistors are arrayed in the X direction and the Z direction. The first interlayer isolation layers and the second interlayer isolation layers isolate the transistors arranged in the Z direction from each other. There is no additional isolation structure between the multiple transistors arranged in the X direction. Therefore, an area occupied by a single transistor is reduced, thereby helping improve integration density of the semiconductor device.

Still as shown in FIG. 4F, in some embodiments, a first source/drain 229 and a second source/drain 230 are respectively formed on two opposite sidewalls of each of the channel portions 228 in the second direction (that is, the Y direction).

It should be noted that, in this embodiment of the present disclosure, the first source/drain 229 is configured to connect to a bit line, and the second source/drain 230 is configured to connect to a storage capacitor. When the first source/drain serves as the source of the transistor, the second source/drain correspondingly serves as the drain of the transistor; and when the first source/drain serves as the drain of the transistor, the second source/drain correspondingly serves as the source of the transistor.

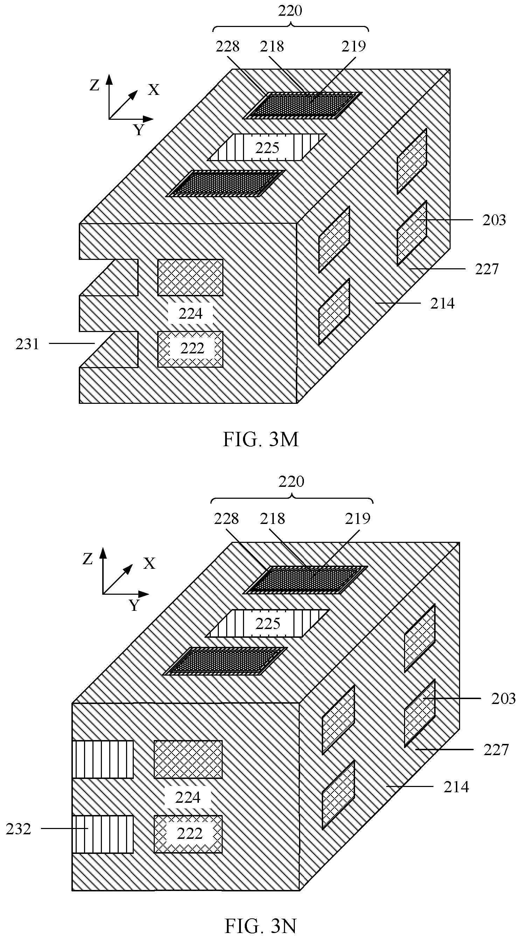

As shown in FIG. 3M, in some embodiments, after the second gaps 226 are filled with the isolation material to form the second interlayer isolation layers 227, the manufacturing method further includes the following step. The semiconductor layers 203 in the fifth stacked sub-structure 213 are removed through etching to form third gaps 231. In this case, the third gaps 231 expose the first source/drain 229.

It should be noted that, as described above, if only the fourth stacked sub-structure 212 in the stacked structure 202 is etched in the procedure of forming the channel holes 215, in this case, the semiconductor layers 203 in the second stacked sub-structure 210 further need to be removed, and bit line contact structures are formed in spaces occupied by the semiconductor layers 203 in the second stacked sub-structure 210. If the fourth stacked sub-structure 212 and the second stacked sub-structure 210 in the stacked structure 202 are etched in the procedure of forming the channel holes 215, in this case, only the semiconductor layers 203 in the fifth stacked sub-structure 213 need to be removed to form the third gaps 231.

A process of forming the third gaps 231 may include but is not limited to wet etching, dry etching, or a combination thereof.

As shown in FIG. 3N, in some embodiments, the third gaps 231 are filled with a conductive material to form multiple bit lines 232 extending in the first direction (that is, the X direction) and electrically connected to the first source/drain 229, and multiple first sources/drains 229 arranged in the X direction are connected to the same bit line 232.

The material of the bit lines 232 may include but is not limited to metal, a metal compound, or alloy. The metal may be, for example, copper, aluminum, tungsten, gold, or silver. The metal compound may be, for example, tantalum nitride or titanium nitride. The alloy may be alloy formed through at least two metal elements in copper, aluminum, tungsten, gold, or silver.

A process of forming the bit lines 232 may include but is not limited to wet etching, dry etching, or a combination thereof.

In some embodiments, bit-line extension lines may be further formed, and the bottoms of different bit-line extension lines are connected to different bit lines.

The bit lines and the bit-line extension lines may be made of the same material or different materials.

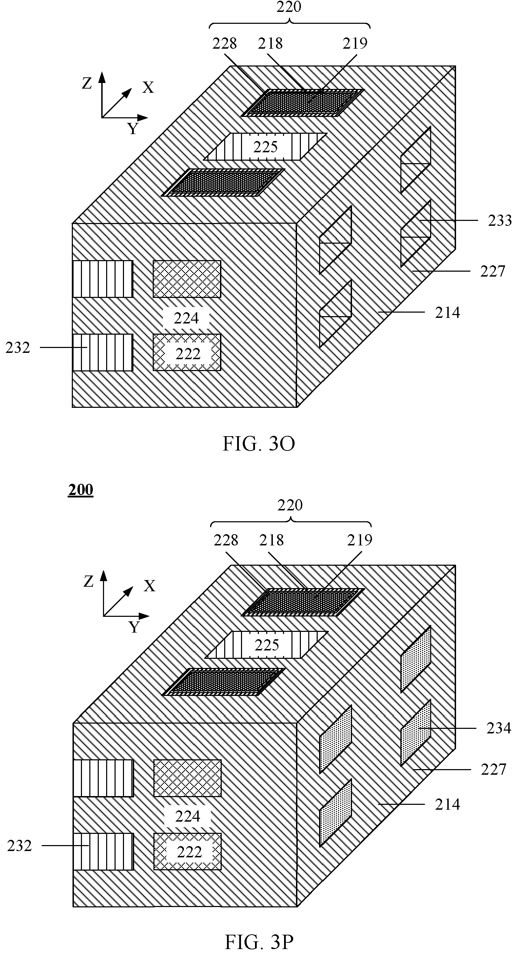

As shown in FIG. 3O, in some embodiments, after the second gaps 226 are filled with the isolation material to form the second interlayer isolation layers 227, the manufacturing method further includes the following step. The semiconductor layers 203 in the third stacked sub-structure 211 are removed through etching to form fourth gaps 233. In this case, the fourth gaps 233 expose the second source/drain 230.

A process of forming the fourth gaps 233 may include but is not limited to wet etching, dry etching, or a combination thereof.

As shown in FIG. 3P, in some embodiments, storage capacitors 234 electrically connected to the second source/drain 230 are formed in the fourth gaps 233. The storage capacitors 234 are arrayed in the X direction and the Z direction, and each of the storage capacitors 234 extends in the Y direction. This helps increase an aspect ratio of the storage capacitors, that is, a ratio of the length to the width or the diameter, so that a distance between storage capacitors of adjacent transistors increases, thereby avoiding an integrated capacitor between the storage capacitors. A specific structure of the storage capacitors is not specifically limited in the present disclosure, and a storage capacitor structure in any related technical solution may be utilized in this solution.

In this embodiment of the present disclosure, the semiconductor layers 203 in the fifth stacked sub-structure 213 are first removed through etching to form the third gaps 231, and the semiconductor layers 203 in the third stacked sub-structure 211 are then removed through etching to form the fourth gaps 233. That is, the bit lines 232 are formed first, and then the storage capacitors 234 are formed.

In another embodiment, the fourth gaps may be formed before the third gaps are formed, that is, the bit lines may be formed before the storage capacitors are formed. A process sequence of forming the third gaps and the fourth gaps is not specifically limited in the present disclosure.

In the embodiment shown in FIG. 3A to FIG. 3P, the threshold voltage regulation structure 225 is formed in the threshold voltage regulation hole 221 after the first interlayer isolation layers 224 are formed in the first gaps 223.

In some embodiments, a sacrificial structure may be formed in the threshold voltage regulation hole after the first interlayer isolation layers are formed in the first gaps. After the bit lines are formed in the third gaps and the storage capacitors are formed in the fourth gaps, the threshold voltage regulation hole is formed through etching, and the threshold voltage regulation structure is formed in the threshold voltage regulation hole.

In some other embodiments, a sacrificial structure may be formed in the threshold voltage regulation hole after the first interlayer isolation layers are formed in the first gaps, and the third gaps and the threshold voltage regulation hole may be simultaneously filled with the conductive material subsequently, to respectively form the bit lines in the third gaps and form the threshold voltage regulation structure in the threshold voltage regulation hole.

In the foregoing embodiment, after the second gaps 226 are filled with the isolation material to form the second interlayer isolation layers 227, the manufacturing method further includes the following steps.

The semiconductor layers 203 in the fifth stacked sub-structure 213 are removed to form the third gaps 231. The third gaps 231 expose the first source/drain 229.

Etching is performed to form the threshold voltage regulation hole 221 running through the first stacked sub-structure 209. The threshold voltage regulation hole 221 is located between adjacent channel holes 215, and the remaining semiconductor layers 203 located between the adjacent channel holes 215 serve as the back gates 222.

The third gaps 231 and the threshold voltage regulation hole 221 are simultaneously filled with the conductive material, to respectively form multiple bit lines 232 extending in the first direction (that is, the X direction) and electrically connected to the first source/drain 229 and the threshold voltage regulation structure 225 electrically connected to the back gates 222. The threshold voltage regulation structure 225 is configured to regulate the threshold voltage of the transistor 220.

A process of forming the third gaps 231 and the threshold voltage regulation hole 221 may include but is not limited to wet etching, dry etching, or a combination thereof.

In this embodiment of the present disclosure, the third gaps 231 and the threshold voltage regulation hole 221 are simultaneously filled with the conductive material, thereby saving manufacturing time and reducing manufacturing costs.

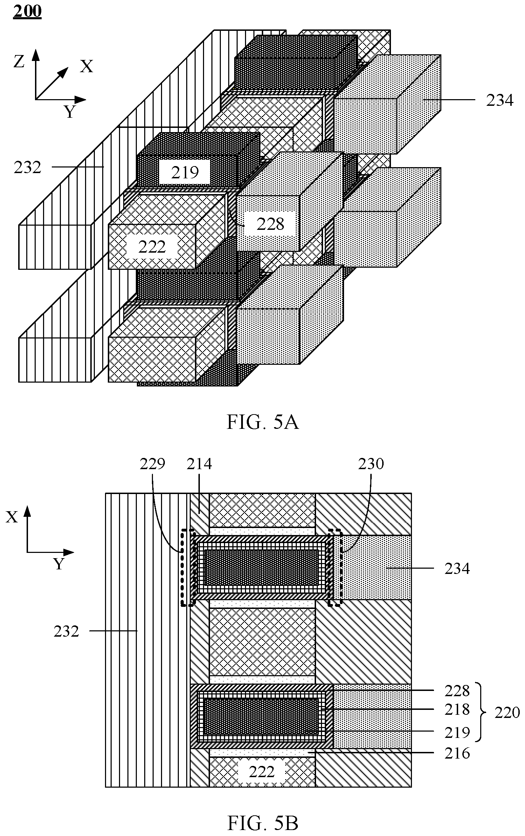

Referring to FIG. 5A and FIG. 5B, FIG. 5A is a schematic diagram of a three-dimensional structure of a semiconductor device according to an example, and FIG. 5B is a schematic diagram of an XY sectional structure of a semiconductor device according to an example. As shown in FIG. 5A and FIG. 5B, an embodiment of the present disclosure provides a semiconductor device 200. The semiconductor device 200 includes: a substrate (not shown in FIG. 5A and FIG. 5B); multiple channel portions 228 arrayed in a first direction (that is, an X direction) and a third direction (that is, a Z direction) and a gate 219 extending in the Z direction and passing through the channel portions 228; a second gate dielectric layer 218 located between the channel portions 228 and the gate 219, where each of the channel portions 228, the second gate dielectric layer 218, and the gate 219 jointly form a transistor 220; a first gate dielectric layer 216 covering two opposite sidewalls of each of the channel portions 228 in the X direction; and back gates 222 located between adjacent transistors 220 arranged in the X direction, the back gates 222 directly contacting the first gate dielectric layer 216, and each of the back gates 222 being configured to regulate a threshold voltage of the transistor 220.

In some embodiments, the material of the channel portions 228 may include but is not limited to an oxide semiconductor material, for example, IGZO, ZTO, IZO, zinc oxide, IGSO, and indium oxide.

In some embodiments, the back gate 222 may be made of a P-type heavily doped polysilicon material with a doping concentration of 1E21 cm⁻³ to 1E23 cm⁻³ and a work function of 4 eV to 5.5 eV. Because the threshold voltage of the transistor made of the IGZO material is inclined to a negative voltage, the threshold voltage of the transistor 220 may be regulated to a positive voltage by disposing the back gate 222, thereby helping reduce electric leakage of the transistor, and prolonging retention time (retention time) of stored data.

The adjacent transistors 220 arranged in the X direction are spaced by the back gate 222 disposed between the transistors 220 without disposing an additional isolation structure, thereby improving a degree of integration of the transistors 220.

The second gate dielectric layer 218 surrounds the gate 219, and the channel portions 228 surround the second gate dielectric layer 218.

In some embodiments, two opposite sidewalls of each of the channel portions 228 in a Y direction respectively form a first source/drain 229 (as shown by a dashed square in FIG. 5B) and a second source/drain 230 (as shown by a dashed square in FIG. 5B). The semiconductor device 200 further includes: bit lines 232 extending in the X direction, where multiple first sources/drains 229 arranged in the X direction are connected to the same bit line 232; and multiple storage capacitors 234, the storage capacitors 234 being connected to second sources/drains 230.

Multiple first sources/drains 229 arranged in the Z direction are connected to different bit lines 232.

In some embodiments, the first source/drain 229 and the second source/drain 230 are respectively aligned with two opposite sidewalls of the back gate 222 in the Y direction, that is, in the Y direction, the size of the back gate 222 is equal to a spacing between the first source/drain 229 and the second source/drain 230. The multiple first sources/drains 229 arranged in the Z direction are connected to the different bit lines 232 through bit line contact structures.

In some embodiments, the multiple first sources/drains 229 arranged in the Z direction are directly connected to the different bit lines 232. The first source/drain 229 protrudes, in the Y direction, from the sidewall of the back gate 222 in the Y direction, and an isolation structure 214 is disposed between the back gate 222 and the bit line. The material of the isolation structure 214 may include a low dielectric constant material, for example, silicon oxide, silicon nitride, silicon carbide, nitrogenous silicon carbide, or silicon oxynitride. The isolation structure 214 may reduce coupling between the bit line 232 and the back gate 222, thereby reducing the parasitic capacitance therebetween.

In some embodiments, both the first source/drain 229 and the second source/drain 230 are not aligned with the two opposite sidewalls of the back gate 222 in the Y direction, the first source/drain 229 protrudes, in the Y direction and toward the bit line 232, from the sidewall of the back gate 222 that is close to the bit line 232 in the Y direction, and the second source/drain 230 protrudes, in the Y direction and toward a direction facing away from the bit line 232, from the sidewall of the back gate 222 that is far away from the bit line 232 in the Y direction, thereby increasing the channel length of the channel portion 228, and reducing a short-channel effect.

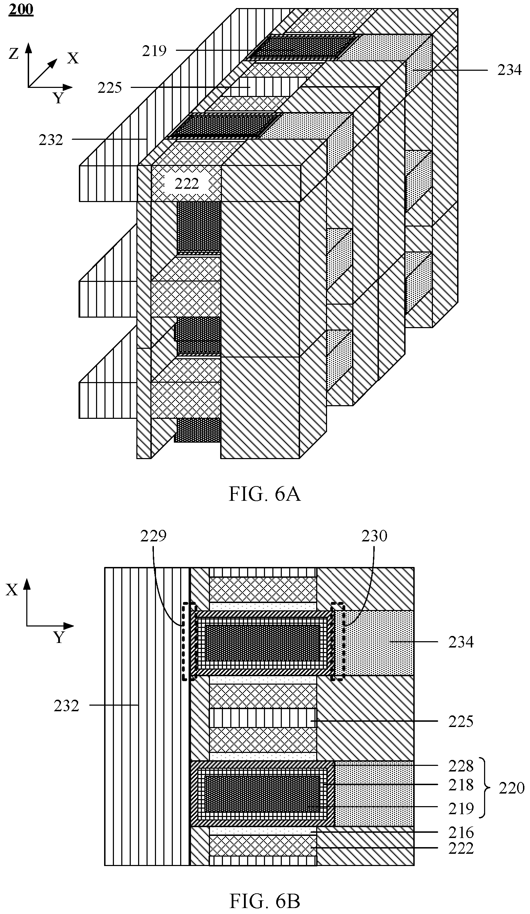

Referring to FIG. 6A and FIG. 6B, FIG. 6A is a schematic diagram of a three-dimensional structure of a semiconductor device according to an example, and FIG. 6B is a schematic diagram of an XY sectional structure of a semiconductor device according to an example. In some embodiments, the semiconductor device 200 further includes a threshold voltage regulation structure 225 located between adjacent back gates 222 of adjacent channel portions 228 arranged in the X direction, the threshold voltage regulation structure 225 extending in the Z direction and being electrically connected to multiple back gates 222 arranged in the Z direction. The threshold voltage regulation structure 225 may be configured to apply a voltage to the back gate 222 to further regulate the threshold voltage of the transistor 220.

In some embodiments, the channel portion 228 is of a ring-shaped structure parallel to the substrate; and the size of the channel portion 228 in the Y direction is greater than or equal to the size of the back gate 222 in the Y direction.

The channel portions 228 are arrayed in the X direction and the Z direction, and each of the channel portions 228 is of a ring-shaped structure parallel to an XY plane.

It should be understood that "an embodiment" or "one embodiment" mentioned throughout the specification means that specific features, structures, or characteristics related to the embodiments are included in at least one embodiment of the present disclosure. Therefore, "in an embodiment" or "in one embodiment" occurring throughout the specification does not necessarily refer to the same embodiment. In addition, these specific features, structures, or characteristics may be combined in one or more embodiments in any appropriate manner. It should be understood that in various embodiments of the present disclosure, sequence numbers of the foregoing processes do not mean an execution sequence. The execution sequence of the processes should be determined based on functions and internal logic of the processes, and should not constitute any limitation on an implementation process of the embodiments of the present disclosure. The sequence numbers of the foregoing embodiments of the present disclosure are merely for the purpose of description, and are not intended to indicate priorities of the embodiments.

The foregoing descriptions are merely preferred implementations of the present disclosure, and are not intended to limit the scope of the present disclosure. Any equivalent structural transformation performed with the content of the specification and the accompanying drawings or directly/indirectly applied in other related technical fields under the present disclosure is included in the protection scope of the present disclosure.

### Industrial applicability

Embodiments of the present disclosure provide a semiconductor device and a manufacturing method therefor. In the embodiments of the present disclosure, multiple channel holes running through a stacked structure are formed, and a gate is formed in each of the channel holes and semiconductor layers in the stacked structure serve as back gates. In this way, a threshold voltage of a transistor can be regulated through the back gate.

## Claims

1. A manufacturing method for a semiconductor device (200), comprising:
providing a substrate (201) and a stacked structure (202) located on the substrate (201), the stacked structure (202) comprising semiconductor layers (203) and interlayer insulating layers (204) that are alternately stacked;
forming a plurality of channel holes (215) running through the stacked structure (202), wherein the semiconductor layers (203) located between adjacent channel holes (215) are configured to form back gates (222);
performing oxidation processing on the semiconductor layers (203) exposed at sidewalls of the channel holes (215) to form first gate dielectric layers (216); and
sequentially forming a channel layer (217), a second gate dielectric layer (218), and a gate (219) that cover sidewalls of each of the channel holes (215); the channel layer (217), the second gate dielectric layer (218), and the gate (219) jointly forming a transistor (220), wherein each of the back gates (222) is configured to regulate a threshold voltage of the transistor (220).

2. The manufacturing method for a semiconductor device (200) according to claim 1, before the forming a plurality of channel holes (215) running through the stacked structure (202), further comprising:
forming a plurality of groove groups (206) running through the stacked structure (202) and arranged in a first direction, each of the groove groups (206) comprising a first groove (207) and a second groove (208) that are disposed side by side in a second direction, wherein the remaining stacked structure (202) comprises a first stacked sub-structure (209) located between the first groove (207) and the second groove (208), a second stacked sub-structure (210) located between adjacent first grooves (207), a third stacked sub-structure (211) located between adjacent second grooves (208), a fourth stacked sub-structure (212) located between adjacent first stacked sub-structures (209), and a fifth stacked sub-structure (213) located on a side of the first groove (207) and a side of the second stacked sub-structure (210), and both the first direction and the second direction are parallel to the substrate (201) and the first direction and the second direction intersect with each other; and
filling the first grooves (207) and the second grooves (208) with an isolation material to form isolation structures (214).

3. The manufacturing method for a semiconductor device (200) according to claim 2, wherein the forming a plurality of channel holes (215) running through the stacked structure (202) comprises:
etching at least the fourth stacked sub-structure (212) in the remaining stacked structure (202) to form the plurality of channel holes (215) running through the stacked structure (214) and arranged in the first direction.

4. The manufacturing method for a semiconductor device (200) according to claim 3, after the sequentially forming a channel layer (217), a second gate dielectric layer (218), and a gate (219) covering sidewalls of each of the channel holes (215), further comprising:
removing the interlayer insulating layers (204) in the first stacked sub-structure (209) to form first gaps (223), the first gaps (223) exposing parts of the channel layer (217) that are disposed opposite to each other in the first direction;
removing the channel layer (217) exposed through the first gaps (223); and
filling the first gaps (223) with an isolation material to form first interlayer isolation layers (224).

5. The manufacturing method for a semiconductor device (200) according to claim 4, wherein the removing the interlayer insulating layers (204) in the first stacked sub-structure (209) to form first gaps (223) comprises:
performing etching to form a threshold voltage regulation hole (221) running through the first stacked sub-structure (209), the threshold voltage regulation hole (221) being located between adjacent channel holes (215), wherein the remaining semiconductor layers (203) located between the adjacent channel holes (215) serve as the back gates (222); and
performing lateral etching along the threshold voltage regulation hole (221) to remove the interlayer insulating layers (204) to form the first gaps (223), the threshold voltage regulation hole (221) and the first gaps (223) being in communication.

6. The manufacturing method for a semiconductor device (200) according to claim 5, wherein the filling the first gaps (223) with an isolation material to form first interlayer isolation layers (224) comprises:
filling the first gaps (223) and the threshold voltage regulation hole (221) with the isolation material;
removing the isolation material from the threshold voltage regulation hole (221), wherein the isolation material located in the first gaps (223) forms the first interlayer isolation layers (224); and
filling the threshold voltage regulation hole (221) with a conductive material to form a threshold voltage regulation structure (225) electrically connected to the back gates (222), the threshold voltage regulation structure (225) being configured to regulate the threshold voltage of the transistor (220).

7. The manufacturing method for a semiconductor device (200) according to any one of claims 4 to 6, after the sequentially forming a channel layer (217), a second gate dielectric layer (218), and a gate (219) covering sidewalls of each of the channel holes (215), further comprising:
removing the interlayer insulating layers (204) in the second stacked sub-structure (210), the third stacked sub-structure (211), and the fifth stacked sub-structure (213) to form second gaps (226), the second gaps (226) exposing parts of the channel layer (217) that are disposed opposite to each other in the second direction;
removing the channel layer (217) exposed through the second gaps (226); and
filling the second gaps (226) with an isolation material to form second interlayer isolation layers (227), wherein the first interlayer isolation layers (224) and the second interlayer isolation layers (227) divide the channel layer (217) in each of the channel holes (215) into channel portions (228) of a plurality of transistors (220), two opposite sidewalls of each of the channel portions (228) in the second direction respectively form a first source/drain (229) and a second source/drain (230), a plurality of transistors (220) arranged in a third direction are connected to a same gate (219), and the third direction is perpendicular to the substrate (201).

8. The manufacturing method for a semiconductor device (200) according to claim 7, after the filling the second gaps (226) with an isolation material to form second interlayer isolation layers (227), further comprising:
removing the semiconductor layers (203) in the fifth stacked sub-structure (213) to form third gaps (231), the third gaps (231) exposing the first source/drain (229); and
filling the third gaps (231) with a conductive material to form a plurality of bit lines (232) extending in the first direction and electrically connected to the first source/drain (229).

9. The manufacturing method for a semiconductor device (200) according to claim 7 or 8, after the filling the second gaps (226) with an isolation material to form second interlayer isolation layers (227), further comprising:
removing the semiconductor layers (203) in the third stacked sub-structure (211) to form fourth gaps (233), the fourth gaps (233) exposing the second source/drain (230); and
forming, in the fourth gaps (223), storage capacitors (234) electrically connected to the second source/drain (230).

10. The manufacturing method for a semiconductor device (200) according to any one of claims 7 to 9, after the filling the second gaps (226) with an isolation material to form second interlayer isolation layers (227), further comprising:
removing the semiconductor layers (203) in the fifth stacked sub-structure (213) to form third gaps (231), the third gaps (231) exposing the first source/drain (229); and
performing etching to form a threshold voltage regulation hole (221) running through the first stacked sub-structure (209), the threshold voltage regulation hole (221) being located between adjacent channel holes (215), wherein the remaining semiconductor layers (203) located between the adjacent channel holes (215) serve as the back gates (222); and
simultaneously filling the third gaps (231) and the threshold voltage regulation hole (221) with the conductive material to respectively form the plurality of bit lines (232) extending in the first direction and electrically connected to the first source/drain (229) and a threshold voltage regulation structure (225) electrically connected to the back gates (222), the threshold voltage regulation structure (225) being configured to regulate the threshold voltage of the transistor (220).

11. A semiconductor device (200), comprising:
a substrate (201);
a plurality of channel portions (228) arrayed in a first direction and a third direction, the first direction being parallel to the substrate (201), and the third direction being perpendicular to the substrate (201);
a gate (219) extending in the third direction and passing through the channel portions (228);
a second gate dielectric layer (218) located between the channel portions (228) and the gate (219), each of the channel portions (228), the second gate dielectric layer (218), and the gate (219) jointly forming a transistor (220);
a first gate dielectric layer (216) covering two sidewalls that are of each of the channel portions (228) and that are disposed opposite to each other in the first direction; and
back gates (222) located between adjacent transistors (220) arranged in the first direction, the back gates (222) being in contact with the first gate dielectric layer (216), and each of the back gates (222) being configured to regulate a threshold voltage of the transistor (220).

12. The semiconductor device (200) according to claim 11, wherein two opposite sidewalls of each of the channel portions (228) in a second direction respectively form a first source/drain (229) and a second source/drain (230); the second direction is parallel to the substrate (201) and intersects with the first direction; and the semiconductor device (200) further comprises:
bit lines (232) extending in the first direction, wherein a plurality of first sources/drains (229) arranged in the first direction are connected to a same bit line (232); and
a plurality of storage capacitors (234), the storage capacitors (234) being connected to the second source/drain (230).

13. The semiconductor device (200) according to claim 11 or 12, further comprising:
a threshold voltage regulation structure (225) located between adjacent back gates (222) of adjacent channel portions (228) arranged in the first direction, the threshold voltage regulation structure (225) extending in the third direction and being electrically connected to a plurality of back gates (222) arranged in the third direction.

14. The semiconductor device (200) according to any one of claims 11 to 13, wherein each of the channel portions (228) is of a ring-shaped structure parallel to the substrate (201); and
a size of the channel portion (228) in the second direction is greater than or equal to a size of the back gate (222) in the second direction.

15. The semiconductor device (200) according to any one of claims 11 to 13, wherein a material of the back gate (222) comprises polysilicon.

16. The semiconductor device (200) according to claim 15, wherein a doping concentration of the back gate (222) is 1E21 cm⁻³ to 1E23 cm⁻³.

17. The semiconductor device (200) according to claim 12, wherein an isolation structure (214) is disposed between the back gate (222) and the bit line (232).

18. The semiconductor device (200) according to claim 17, wherein a material of the isolation structure (214) comprises a low dielectric constant material.
